# EUROPEAN PATENT APPLICATION

(11) **EP 4 503 885 A1**
(43) Date of publication of application: **05.02.2025**
(21) Application number: 24190342.6
(22) Date of filing: 23.07.2024
(51) Int. Cl.: H10B 41/27, H10B 41/50, H10B 43/27, H10B 43/50, H10B 41/10, H10B 43/10, H01L 25/00, G11C 5/02

(54) **SEMICONDUCTOR MEMORY DEVICE AND ELECTRONIC SYSTEM INCLUDING THE SAME**

(30) Priority: 04.08.2023 KR 20230102332
(71) Applicant: Samsung Electronics Co., Ltd, Suwon-si, Gyeonggi-do 16677 (KR)
(72) Inventor: KIM, Jiyoung, 16677 Suwon-si (KR); KIM, Junhyoung, 16677 Suwon-si (KR); KWON, Joonyoung, 16677 Suwon-si (KR); KIM, Siwan, 16677 Suwon-si (KR); SUNG, Sukkang, 16677 Suwon-si (KR)
(74) Representative: Marks & Clerk LLP

(57) **Abstract**

A semiconductor memory device including a cell array structure (CS) and a peripheral circuit structure (PS) is provided. The cell array structure includes a first stack structure (ST1), a second stack structure (ST2) on the first stack structure, and a third stack structure (ST3) on the second stack structure, each of the first to third stack structures including a plurality of word lines (EL1, EL2, EL3), vertical channel structures (VS) extending into the first to third stack structures, and a second cell contact plug (CP2a, CP2b) extending into the first to third stack structures and connected to a second contact plug at an end of a second word line in the second stack structure. The second cell contact plug includes a first horizontal protrusion (LP1, LP2) having a horizontal width that increases discontinuously at a connection portion of the first stack structure and the second stack structure.

## Description

The inventive concept relates generally to a semiconductor memory device, a method of manufacturing the same, and an electronic system including the same, and more specifically, relates to a semiconductor memory device including a peripheral circuit structure and a cell array structure coupled to each other through bonding pads, a method of manufacturing the same, and an electronic system including the same.

### BACKGROUND

A semiconductor device capable of storing a large amount of data may be required as a part of an electronic system. Higher integration of semiconductor devices may be required to satisfy consumer demands for large data storing capacity, superior performance, and inexpensive prices. In the case of two-dimensional or planar semiconductor devices, since their integration mainly may be determined by the area occupied by a unit memory cell, integration may be influenced by the resolution of a fine pattern forming technology. However, extremely expensive process equipment may be needed to increase pattern fineness and may set a practical limitation on increasing integration for two-dimensional or planar semiconductor devices. Thus, three-dimensional semiconductor memory devices including three-dimensionally arranged memory cells have recently been proposed.

### SUMMARY

An object of the inventive concept is to provide a three-dimensional semiconductor memory device with improved electrical characteristics and reliability and a method of manufacturing the same.

An object of the inventive concept is to provide a three-dimensional semiconductor memory device capable of simplifying processes and a method of manufacturing the same.

Problems to be addressed by the inventive concept are not limited to the problems mentioned above, and other problems to which the present disclosure may provide a solution not explicitly discussed herein may become apparent to those skilled in the art from the description below.

A semiconductor memory device according to some embodiments of the inventive concept may include a cell array structure and a peripheral circuit structure. The cell array structure may include a first stack structure, a second stack structure on the first stack structure, and a third stack structure on the second stack structure, each of the first, to third stack structures including a plurality of word lines, vertical channel structures penetrating (i.e., extending into or through) the first to third stack structures, and a second cell contact plug extending into the first to third stack structures and connected to a second contact pad at an end of a second word line in the second stack structure, and the second cell contact plug may include a first horizontal protrusion having a horizontal width that increases discontinuously at a connection portion of the first stack structure and the second stack structure.

A semiconductor memory device according to some embodiments of the inventive concept may include a peripheral circuit structure and a cell array structure on the peripheral circuit structure. The cell array structure may include a semiconductor layer, a first stack structure on the semiconductor layer, a second stack structure on the first stack structure, and a third stack structure on the second stack structure, the first to third stack structures provided between the semiconductor layer and the peripheral circuit structure and each including a plurality of word lines. The cell array structure may further include vertical channel structures extending into the first to third stack structures, a first cell contact plug extending into the first to third stack structures and connected to a first contact pad at an end of a first word line in the first stack structure, a second cell contact plug extending into the first to third stack structures and connected to a second contact pad at an end of a second word line in the second stack structure, and a third cell contact plug extending into the first to third stack structures and connected to a third contact pad at an end of a third word line in the third stack structure. The second cell contact plug may include a first horizontal protrusion having a horizontal width that increases discontinuously at a connection portion of the first stack structure and the second stack structure.

An electronic system according to some embodiments of the inventive concept may include a three-dimensional semiconductor memory device comprising a peripheral circuit structure and a cell array structure provided on the peripheral circuit structure and including a cell array region and a cell array contact region and a controller electrically connected to the three-dimensional semiconductor memory device through an input/output pad and controlling the three-dimensional semiconductor memory device. The cell array structure may include a first stack structure, a second stack structure, and a third stack structure each including a plurality of word lines, vertical channel structures penetrating the first to third stack structures, and a second cell contact plug penetrating the first to third stack structures and penetrating a second contact pad provided at an end of a second word line in the second stack structure, and the second cell contact plug may include a first horizontal protrusion having a horizontal width that increases discontinuously at a connection portion of the first stack structure and the second stack structure.

At least some of the above and other features of the invention are set out in the claims.

### BRIEF DESCRIPTION OF THE DRAWINGS

Example embodiments will be more clearly understood from the following brief description taken in conjunction with the accompanying drawings, wherein like reference numerals (when used) indicate corresponding elements throughout the several views. The accompanying drawings represent non-limiting, example embodiments as described herein.
FIG. 1 is a schematic diagram illustrating an example electronic system including a three-dimensional semiconductor memory device according to one or more embodiments of the inventive concept.
FIG. 2 is a perspective view schematically illustrating an example electronic system including a three-dimensional semiconductor memory device according to one or more embodiments of the inventive concept.
FIGS. 3 and 4 are cross-sectional views, which are respectively taken along lines I-I' and II-II' of FIG. 2 to illustrate a semiconductor package including a three-dimensional semiconductor memory device, according to an embodiment of the inventive concept.
FIG. 5 is a top plan view illustrating a three-dimensional semiconductor memory device according to embodiments of the inventive concept, and is a plan view based on LV1 of FIG. 8.
FIG. 6 is a top plan view illustrating a three-dimensional semiconductor memory device according to embodiments of the inventive concept, and is a plan view based on LV2 of FIG. 8.
FIG. 7 is a top plan view illustrating a three-dimensional semiconductor memory device according to embodiments of the inventive concept, and is a plan view based on LV3 in FIG. 8.
FIG. 8 is a cross-sectional view illustrating a three-dimensional semiconductor memory device according to embodiments of the inventive concept, taken along line I-I' of FIG. 5.
FIG. 9 is an enlarged view of region `ZR' of the three-dimensional semiconductor memory device shown in FIG. 8.
FIG. 10 is an enlarged view of region 'R' shown in FIG. 9 of the three-dimensional semiconductor memory device shown in FIG. 8.
FIGS. 11, 15 to 18, and 23 to 24 are cross-sectional views taken along line I-I' of FIG. 5 illustrating intermediate processes in an example method of manufacturing a three-dimensional semiconductor memory device according to embodiments of the inventive concept.
FIGS. 12 to 14 are enlarged cross-sectional views of region `Q1' in FIG. 11 during manufacturing of a three-dimensional semiconductor memory device according to embodiments of the inventive concept.
FIGS. 19 to 22 are enlarged cross-sectional views of region `Q2' in FIG.18 during manufacturing of a three-dimensional semiconductor memory device according to embodiments of the inventive concept.

### DETAILED DESCRIPTION

Hereinafter, a semiconductor memory device, a manufacturing method thereof, and an electronic system including the same according to embodiments of the inventive concept will be described in detail with reference to the drawings.

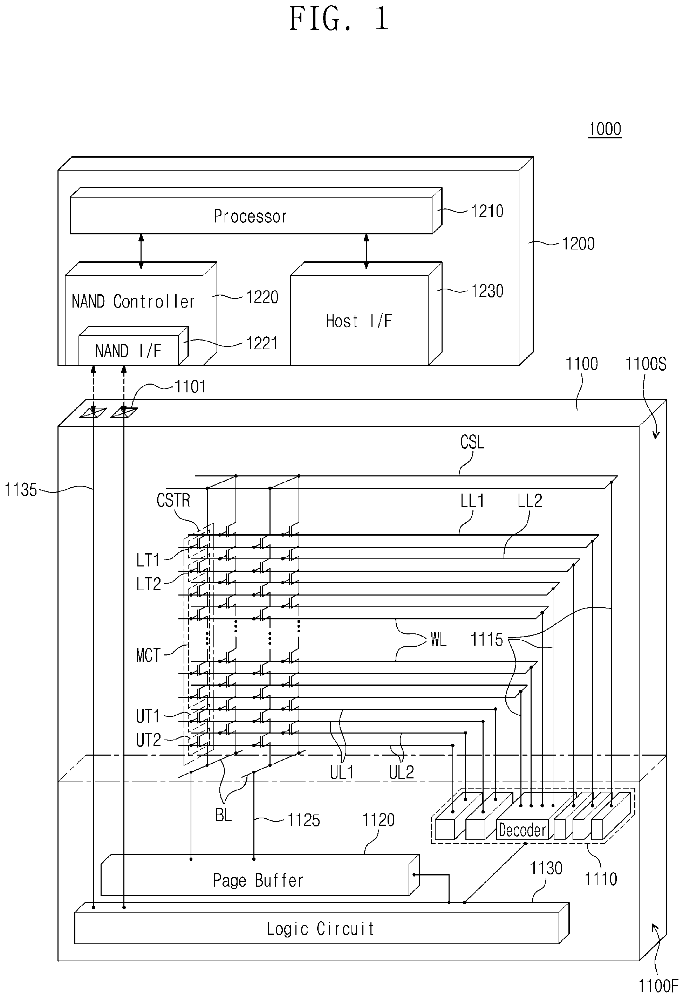

FIG. 1 is a schematic diagram illustrating an example electronic system including a three-dimensional semiconductor memory device, according to one or more embodiments of the inventive concept.

Referring to FIG. 1, an electronic system 1000 according to some embodiments of inventive concepts may include a semiconductor device 1100 and a controller 1200, which are electrically connected to each other. The term "connected" (or "connecting," "contact," "contacting," or like terms), as may be used herein, is intended to refer to a physical and/or electrical connection between two or more elements, and may include other intervening elements. As used herein, the term "and/or" includes any and all combinations of one or more of the associated listed items. The electronic system 1000 may be or may include a storage device including one or more semiconductor devices 1100 and/or an electronic device including the storage device. For example, the electronic system 1000 may be or may include, for example, at least one of a solid-state drive (SSD) device, a universal serial bus (USB), a computing system, a medical system, or a communication system, in which at least one semiconductor device 1100 is provided.

The three-dimensional semiconductor memory device 1100 may be a nonvolatile memory device, and for example may be a three-dimensional NAND flash memory device. The three-dimensional semiconductor memory device 1100 may include a first region 1100F and a second region 1100S on the first region 1100F. However, unlike the example illustrated in the drawings, the first region 1100F alternatively may be disposed at a side of the second region 1100S. The first region 1100F may be, for example, a peripheral circuit region, which includes a decoder 1110, a page buffer 1120, and a logic circuit 1130. The second region 1100S may be a memory cell region, which includes bit lines BL, a common source line CSL, word lines WL, first lines LL1 and LL2, second lines UL1 and UL2, and memory cell strings CSTR between the bit lines BL and the common source line CSL.

In the second region 1100S, each of the memory cell strings CSTR may include first transistors LT1 and LT2 adjacent to the common source line CSL, second transistors UT1 and UT2 adjacent to the bit lines BL, and a plurality of memory cell transistors MCT disposed between the first transistors LT1 and LT2 and the second transistors UT1 and UT2. The number of the first transistors LT1 and LT2 and the number of the second transistors UT1 and UT2 may be variously changed, according to embodiments; furthermore, the number of first transistors LT1, LT2 need not be the same as the number of second transistors UT1, UT2. The memory cell strings CSTR may be positioned between the common source line CSL and the first region 1100F.

For example, the second transistors UT1 and UT2 may include string selection transistors, and the first transistors LT1 and LT2 may include ground selection transistors. The first lines LL1 and LL2 may serve as gate electrodes of the first transistors LT1 and LT2. The word lines WL may serve as gate electrodes of the memory cell transistors MCT, and the second lines UL1 and UL2 may serve as gate electrodes of the second transistors UT1 and UT2.

The common source line CSL, the first lines LL1 and LL2, the word lines WL, and the second lines UL1 and UL2 may be electrically connected to the decoder 1110 through first interconnection lines 1115, which extend between the first region 1100F and the second region 1100S. The bit lines BL may be electrically connected to the page buffer 1120 through second interconnection lines 1125, which extend between the first region 1100F and the second region 1100S.

In the first region 1100F, the decoder 1110 and the page buffer 1120 may be configured to control a control operation, which is performed on at least a selected one of the memory cell transistors MCT. The decoder 1110 and/or the page buffer 1120 may be controlled, at least in part, by the logic circuit 1130. The three-dimensional semiconductor memory device 1100 may communicate with the controller 1200 through one or more input/output pads 1101, which are electrically connected to the logic circuit 1130. The input/output pad(s) 1101 may be electrically connected to the logic circuit 1130 through one or more corresponding input/output interconnection lines 1135, which extend between the first region 1100F and the second region 1100S.

The controller 1200 may include a processor 1210, a NAND controller 1220, and a host interface (I/F) 1230. In an embodiment, the electronic system 1000 may include a plurality of three-dimensional semiconductor memory devices 1100, and in this case, the controller 1200 may control the plurality of three-dimensional semiconductor memory devices 1100.

The processor 1210 may control overall operations of the electronic system 1000 including the controller 1200. Based on a specific firmware, the processor 1210 may execute operations of controlling the NAND controller 1220 and accessing the three-dimensional semiconductor memory device 1100. The NAND controller 1220 may include a NAND interface 1221, which may be used for communication with the three-dimensional semiconductor memory device 1100. The NAND interface 1221 may be used to transmit and/or receive control commands to control the three-dimensional semiconductor memory device 1100, data to be written in or read from the memory cell transistors MCT of the three-dimensional semiconductor memory device 1100, and so forth. The host interface 1230 may be configured to allow for communication between the electronic system 1000 and an external host (not explicitly shown). When a control command is provided from an external host through the host interface 1230, the processor 1210 may control the semiconductor device 1100 in response to the control command.

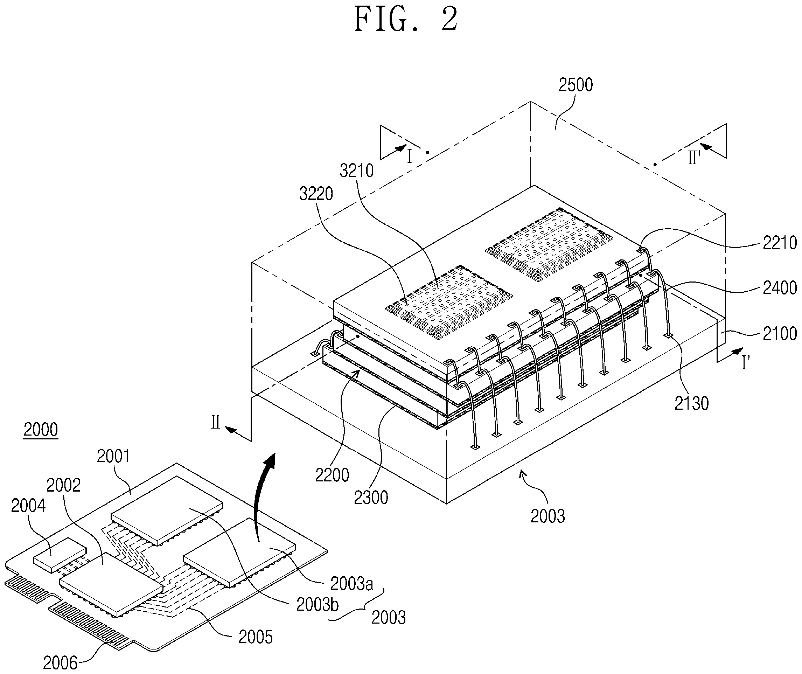

FIG. 2 is a perspective view schematically illustrating an example electronic system including a three-dimensional semiconductor memory device according to one or more embodiments of the inventive concept.

Referring to FIG. 2, an electronic system 2000 may include a main substrate 2001 and a controller 2002, one or more semiconductor packages 2003, and a dynamic random-access memory (DRAM) 2004, which are mounted on the main substrate 2001. The semiconductor package(s) 2003 and the DRAM 2004 may be connected to the controller 2002 and to each other by interconnection patterns 2005, which may be provided in the main substrate 2001.

The main substrate 2001 may include a connector 2006, which includes a plurality of pins coupled to an external host (not explicitly shown). In the connector 2006, the number and the arrangement of the pins may be changed depending on a type (e.g., protocol) of communication interface between the electronic system 2000 and an external host. For example, the electronic system 2000 may communicate with the external host, in accordance with one or more interfaces, such as, for example, universal serial bus (USB), peripheral component interconnect express (PCI-Express), serial advanced technology attachment (SATA), universal flash storage (UFS) M-PHY, or the like. In an embodiment, the electronic system 2000 may be driven by electric power, which is supplied from the external host through the connector 2006. The electronic system 2000 may further include a power management integrated circuit (PMIC) for separately supplying the electric power, which is provided from the external host, to the controller 2002 and the semiconductor package(s) 2003.

The controller 2002 may control a writing and/or reading operation on the semiconductor package(s) 2003 and may improve an operation speed of the electronic system 2000.

The DRAM 2004 may be a buffer memory, which relieves technical difficulties caused by a difference in speed between the semiconductor package(s) 2003, which serves as a data storage device, and an external host. The DRAM 2004 in the electronic system 2000 may serve as a cache memory and may provide a storage space, in which data can be temporarily stored when a control operation is executed on the semiconductor package(s) 2003. When the electronic system 2000 includes the DRAM 2004, the controller 2002 may further include a DRAM controller that is used to control the DRAM 2004, in addition to a NAND controller that is used to control the semiconductor package(s) 2003.

The semiconductor package(s) 2003 may include first and second semiconductor packages 2003a and 2003b, which are spaced apart from each other on the main substrate 2001. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200, which are provided on the package substrate 2100, adhesive layers 2300, which are respectively disposed on lower surfaces of the semiconductor chips 2200, connection structures 2400, which may be used to electrically connect the semiconductor chips 2200 to the package substrate 2100, and a molding layer 2500, which is provided on the package substrate 2100 to cover the semiconductor chips 2200 and the connection structures 2400. The term "cover" (or "covering," or like terms), as may be used herein, is intended to broadly refer to an element, structure or layer that is on or over another element, structure or layer, either directly or with one or more other intervening elements, structures or layers therebetween.

The package substrate 2100 may be a printed circuit board including package upper pads 2130. Each of the semiconductor chips 2200 may include one or more input/output pads 2210. Each of the input/output pads 2210 may correspond to the input/output pad 1101 of FIG. 1. Each of the semiconductor chips 2200 may include gate stacks 3210 and memory channel structures 3220. Each of the semiconductor chips 2200 may include a three-dimensional semiconductor memory device, which will be described below.

The connection structures 2400 may be, for example, bonding wires, which are provided to electrically connect the input/output pads 2210 to the package upper pads 2130. That is, in each of the first and second semiconductor packages 2003a and 2003b, the semiconductor chips 2200 may be electrically connected to each other in a bonding wire manner and may be electrically connected to the package upper pads 2130 of the package substrate 2100. In some embodiments, the semiconductor chips 2200 in each of the first and second semiconductor packages 2003a and 2003b may be electrically connected to each other by through silicon vias (TSVs), and not by the connection structure 2400 provided in the form of bonding wires.

Unlike the example illustrated in FIG. 2, the controller 2002 and the semiconductor chips 2200 may be included in a single package rather than in separate packages; that is, the controller 2002 may be integrated in one or more of the semiconductor chips 2200. In an embodiment, the controller 2002 and the semiconductor chips 2200 may be mounted on a separate interposer substrate, not on the main substrate 2001, and may be connected to each other through interconnection lines, which are provided in the interposer substrate.

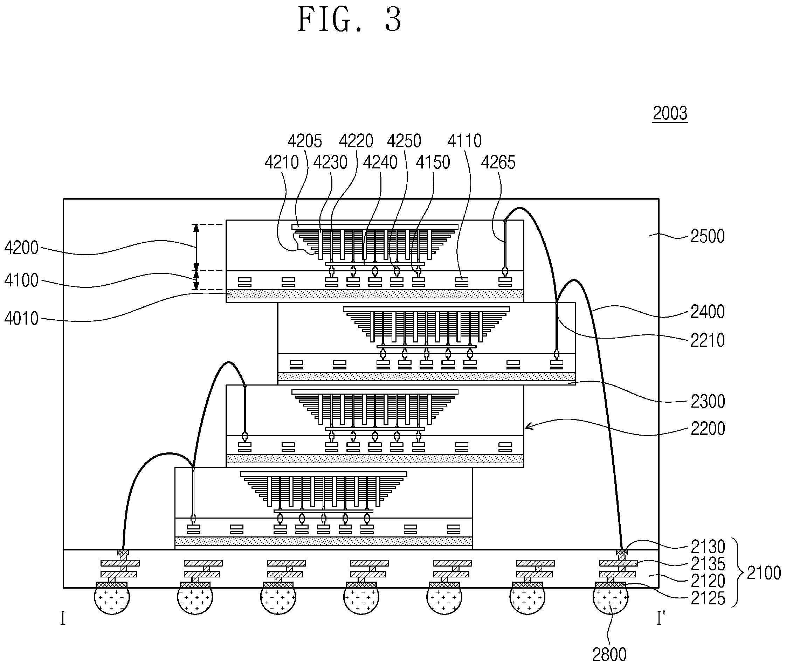

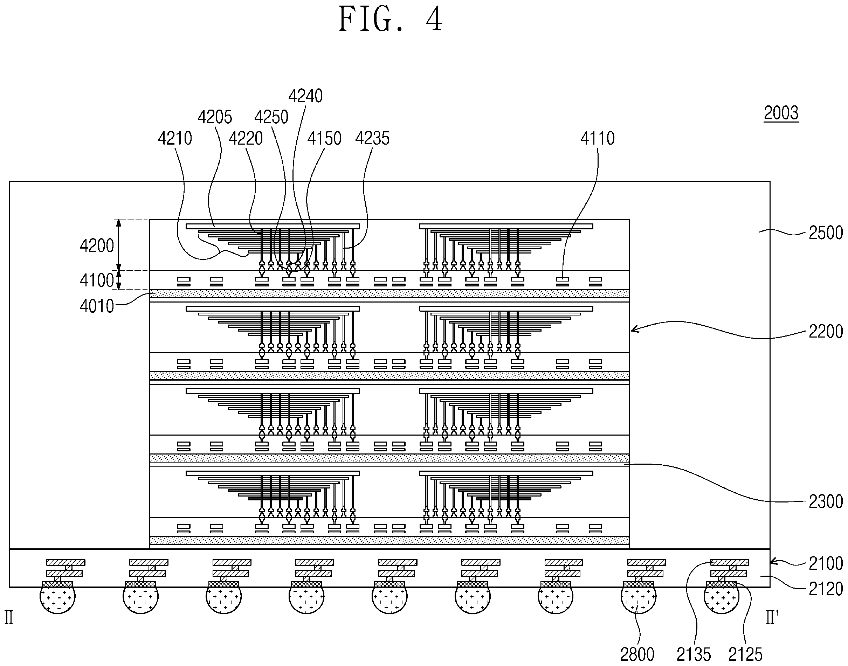

FIGS. 3 and 4 are sectional views, which are respectively taken along lines I-I' and II-II' of FIG. 2 to illustrate a semiconductor package including a three-dimensional semiconductor memory device, according to an embodiment of inventive concepts.

Referring to FIGS. 3 and 4, the semiconductor package 2003 may include the package substrate 2100, the semiconductor chips 2200 on the package substrate 2100, and the molding layer 2500 covering (i.e., on or over) the package substrate 2100 and the semiconductor chips 2200.

The package substrate 2100 may include a package substrate body portion 2120, upper pads 2130, which are provided on an upper surface of the package substrate body portion 2120 and are exposed to the outside of the package substrate body portion 2120 near the upper surface, lower pads 2125, which are provided on a bottom surface of the package substrate body portion 2120 or are exposed to the outside of the package substrate body portion 2120 near the bottom surface, and internal lines 2135, which are provided in the package substrate body portion 2120 to electrically connect the upper pads 2130 to the lower pads 2125. The term "exposed" (or "expose," or like terms) may be used herein to describe relationships between elements and/or with reference to intermediate processes in fabricating a semiconductor device, but may not require exposure of a particular element in the completed device. Likewise, the term "not exposed" may be used to described relationships between elements and/or with reference to intermediate processes in fabricating a semiconductor device, but may not require a particular element to be unexposed in the completed device. The upper pads 2130 may be electrically connected to the connection structures 2400. The lower pads 2125 may be connected to the interconnection patterns 2005 of the main substrate 2001 of the electronic system 2000, which is shown in FIG. 2, through conductive connecting portions 2800 (e.g., solder bumps, etc.).

Referring to FIGS. 2 and 3, the semiconductor chips 2200 may be provided such that some side surfaces thereof are not vertically aligned to each other, or at least a subset of the semiconductor chips 2200 may have side surfaces that are vertically aligned with another. The semiconductor chips 2200 may be electrically connected to each other through the connection structures 2400, which are provided in the form of bonding wires. Each of the semiconductor chips 2200 may include substantially the same elements.

Each of the semiconductor chips 2200 may include a semiconductor substrate 4010, a first structure 4100 on the semiconductor substrate 4010, and a second structure 4200 on the first structure 4100. The second structure 4200 may be connected to the first structure 4100 in a wafer bonding manner.

The first structure 4100 may include peripheral circuit interconnection lines 4110 and first bonding pads 4150. The second structure 4200 may include a common source line 4205, a gate stack 4210, which is provided between the common source line 4205 and the first structure 4100, memory channel structures 4220 and separation structures 4230, which are provided to vertically penetrate (i.e., extend into) the gate stack 4210, and second bonding pads 4250, which are respectively connected to the memory channel structures 4220 and the word lines WL (e.g., see FIG. 1) of the gate stack 4210. For example, the second bonding pads 4250 may be electrically connected to the memory channel structures 4220 and the word lines WL, respectively, through bit lines 4240, which are electrically connected to the memory channel structures 4220, and gate interconnection lines 4235 (FIG. 4), which are electrically connected to the word lines WL. The first bonding pads 4150 of the first structure 4100 and the second bonding pads 4250 of the second structure 4200 may be in contact with each other and may be coupled to each other. The coupling portions between the first bonding pads 4150 and the second bonding pads 4250 may be formed of or include, for example, copper (Cu).

Each of the semiconductor chips 2200 may further include the input/output pad 2210 and an input/output interconnection line 4265 below the input/output pad 2210. The input/output interconnection line 4265 may be electrically connected to some of the second bonding pads 4250 and some of the peripheral circuit interconnection lines 4110.

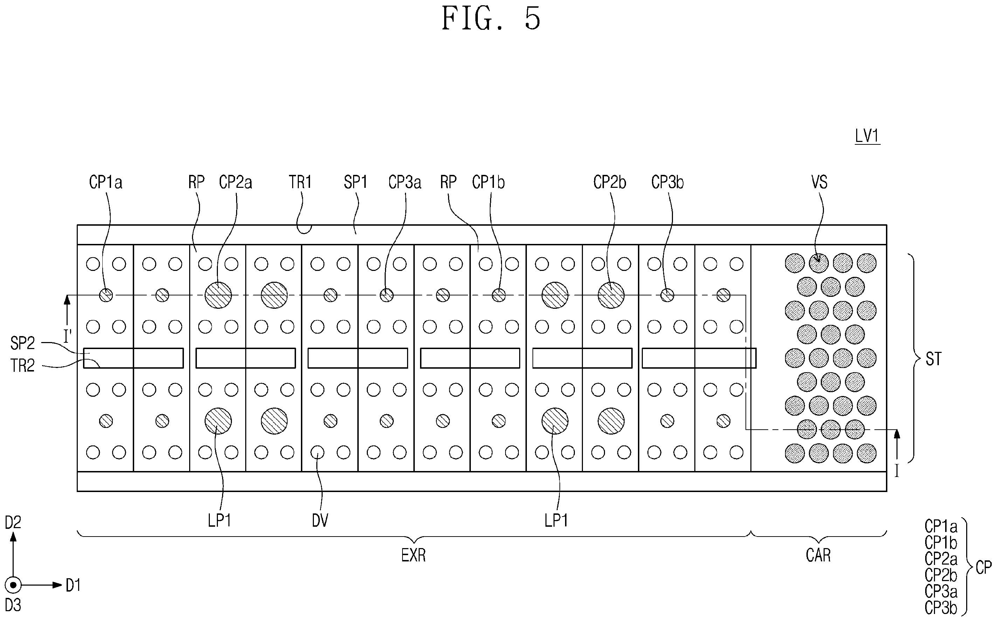

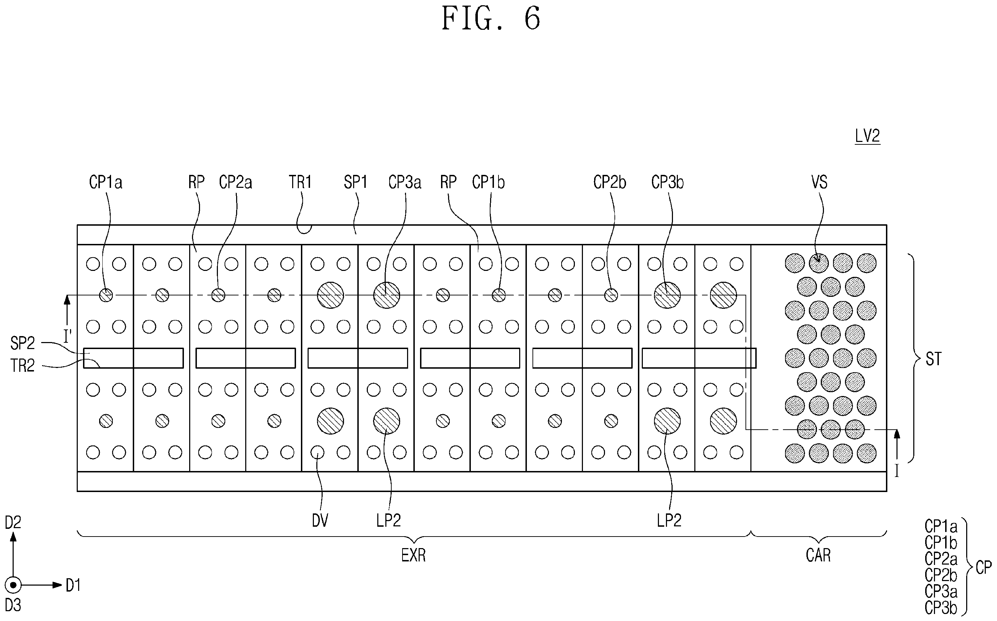

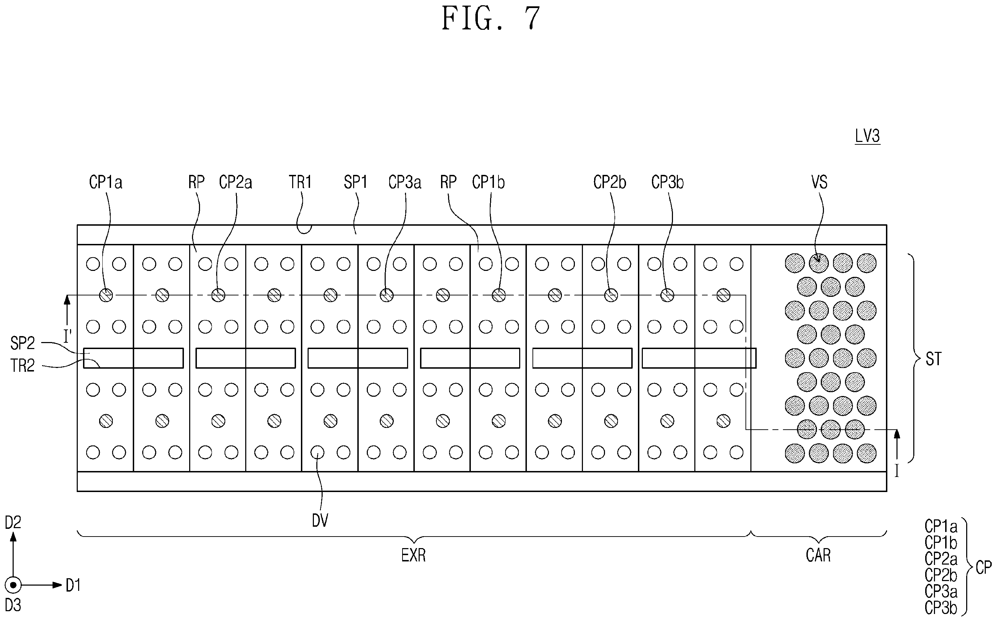

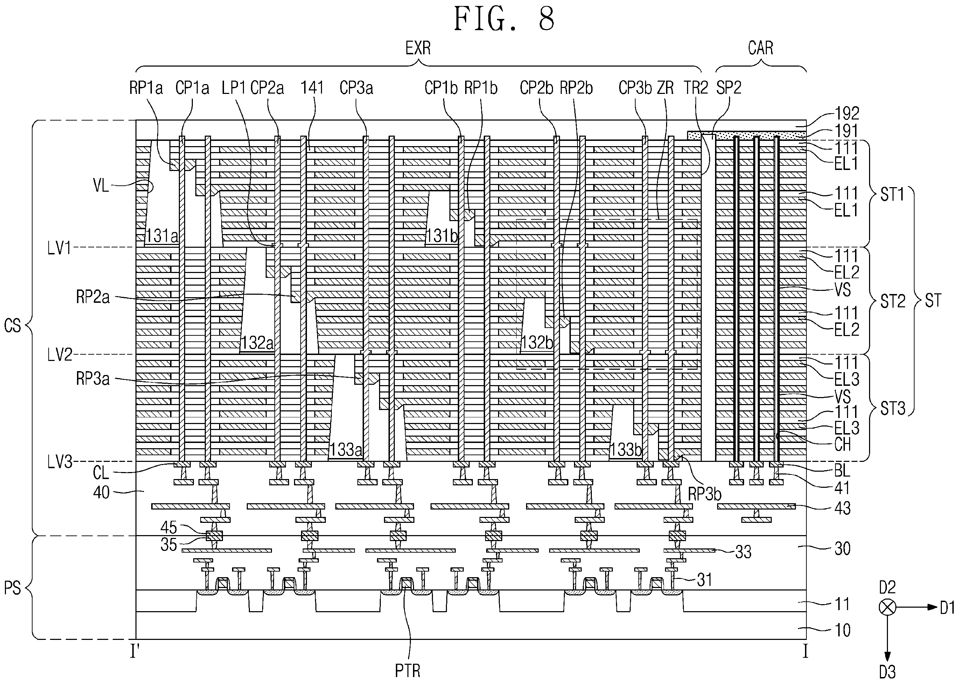

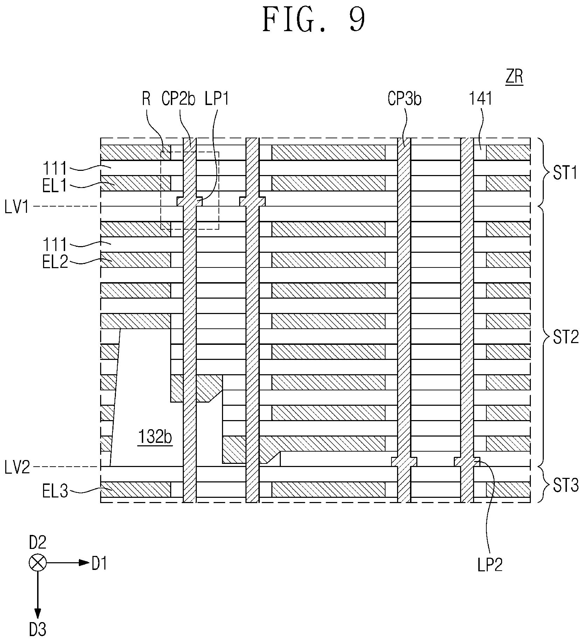

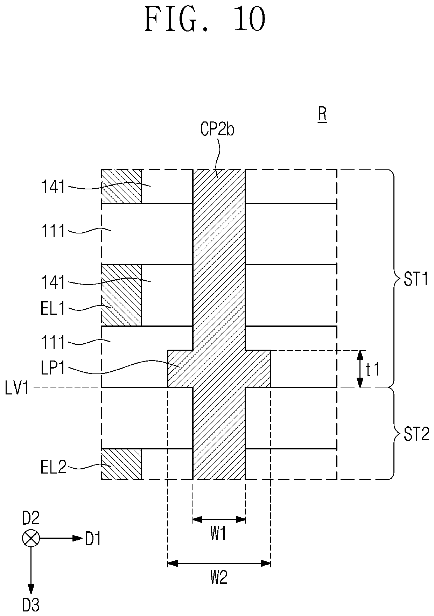

FIG. 5 is a top plan view illustrating a three-dimensional semiconductor memory device according to embodiments of the inventive concept, and is based on LV1 shown in FIG. 8. FIG. 6 is a top plan view illustrating a three-dimensional semiconductor memory device according to embodiments of the inventive concept, and is based on LV2 shown in FIG. 8. FIG. 7 is a top plan view illustrating a three-dimensional semiconductor memory device according to embodiments of the inventive concept, and is based on LV3 shown in FIG. 8. FIG. 8 is a cross-sectional view illustrating a three-dimensional semiconductor memory device according to embodiments of the inventive concept, taken along line I-I' of FIG. 5. FIG. 9 is an enlarged cross-sectional view of region `ZR' of the three-dimensional semiconductor memory device shown in FIG. 8. FIG. 10 is an enlarged cross-sectional view of region 'R' shown in FIG. 9 of the three-dimensional semiconductor memory device shown in FIG. 8.

Referring to FIGS. 5 to 10, a three-dimensional semiconductor memory device according to the inventive concept may include a peripheral circuit structure PS and a cell array structure CS provided on the peripheral circuit structure PS in a vertical direction (third direction D3) perpendicular to an upper surface of a first substrate 10. The cell array structure CS may be bonded on the peripheral circuit structure PS, and thus a cell capacity per unit area of the three-dimensional semiconductor memory device according to the inventive concept may be increased. In addition, forming the peripheral circuit structure PS and the cell array structure CS separately and combining them (after formation of the circuit elements/structures therein) may prevent damage to the peripheral transistors PTR due to various heat treatment processes, thereby improving electrical characteristics and reliability of the semiconductor memory devices.

The peripheral circuit structure PS may include the first substrate 10. The first substrate 10 may be, for example, a silicon substrate, a silicon-germanium substrate, a germanium substrate, or a single crystal epitaxial layer grown on a monocrystalline silicon substrate. The first substrate 10 may have a first conductivity type. As an example, the first conductivity type may be p-type. The first substrate 10 may have an upper surface parallel to a first direction D1 and a second direction D2 that intersects the first direction D1 (i.e. a second direction D2 that is different to the first direction D1), and orthogonal to the third direction D3; the first and second directions D1, D2 may be horizontal directions. For example, the first to third directions D1, D2, and D3 may be directions orthogonal to each other. A device isolation layer 11 may be provided in the first substrate 10. The device isolation layer 11 may define an active region of the first substrate 10.

Peripheral transistors PTR on the first substrate 10, peripheral contact plugs 31, peripheral circuit lines 33 electrically connected to the peripheral transistors PTR through the peripheral contact plugs 31, and a peripheral insulating layer 30 surrounding the peripheral circuit lines 33, the peripheral transistors PTR, and the peripheral contact plugs 31, may be provided. The term "surrounding" (or "surrounds," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles. The peripheral transistors PTR may be provided on the active region of the first substrate 10. The peripheral circuit lines 33 may correspond to the peripheral circuit interconnection lines 4110 of FIGS. 3 and 4, and first bonding pads 35 may correspond to the first bonding pads 4150 of FIGS. 3 and 4.

For example, a width of the peripheral contact plugs 31 in the first direction D1 and/or the second direction D2 may decrease as the peripheral contact plugs 31 extend toward the first substrate 10 in the third direction D3. The peripheral contact plugs 31 and peripheral circuit lines 33 may include a conductive material such as metal.

The peripheral transistors PTR may constitute, for example, a decoder (1110 in FIG. 1), a page buffer (1120 in FIG. 1), and/or a logic circuit (1130 in FIG. 1). In detail, each of the peripheral transistors PTR may include a peripheral gate insulating layer, a peripheral gate electrode, a peripheral capping pattern, a peripheral gate spacer, and peripheral source/drain regions. The peripheral gate insulating layer may be provided between the peripheral gate electrode and the first substrate 10. The peripheral capping pattern may be provided on the peripheral gate electrode. The peripheral gate spacer may cover sidewalls of the peripheral gate insulating layer, the peripheral gate electrode, and the peripheral capping pattern. The peripheral source/drain regions may be provided inside the first substrate 10 adjacent to both sides of the peripheral gate electrode. The peripheral circuit lines 33 and the first bonding pads 35 may be electrically connected to the peripheral transistors PTR through the peripheral contact plugs 31. Each of the peripheral transistors PTR may be, for example, an n-channel metal-oxide-semiconductor (NMOS) transistor or a p-channel metal-oxide-semiconductor (PMOS) transistor.

The peripheral insulating layer 30 may be provided on the first substrate 10. The peripheral insulating layer 30 may cover the peripheral transistors PTR, peripheral contact plugs 31, and peripheral circuit lines 33 on the first substrate 10. The peripheral insulating layer 30 may include a plurality of insulating layers having a multilayer structure. For example, the peripheral insulating layer 30 may include silicon oxide, silicon nitride, silicon oxynitride, and/or a low dielectric material. The peripheral insulating layer 30 may not cover upper surfaces of the first bonding pads 35; that is, at least a portion of the respective upper surfaces of the first bonding pads 35 may be exposed through the peripheral insulating layer 30. The upper surface of the peripheral insulating layer 30 may be substantially coplanar (in the vertical direction) with the upper surfaces of the first bonding pads 35.

The cell array structure CS including second bonding pads 45, bit lines BL, a stack structure ST, and a semiconductor layer 191 may be provided on the peripheral circuit structure PS. The cell array structure CS may include a cell array region CAR and an extension region EXR. The extension region EXR may extend horizontally from the cell array region CAR in a direction opposite to the first direction D1 (or in the first direction D1).

The second bonding pads 45, bit lines BL, and stack structure ST may correspond to the second bonding pads 4250, bit lines 4240, and gate stack structure 4210 of FIGS. 3 and 4. First interconnection lines 43 are electrically connected to the second bonding pads 45. The first interconnection lines 43 are also electrically connected to second interconnection lines CL through connection contact plugs 41. The second bonding pads 45 are in contact with the first bonding pads 35 of the peripheral circuit structure PS, and a cell insulating layer 40 surrounding the first interconnection lines 43, connection contact plugs 41, and second bonding pads 45, may be provided.

The cell insulating layer 40, in some embodiments, may include a plurality of insulating layers having a multilayer structure. For example, the cell insulating layer 40 may include silicon oxide, silicon nitride, silicon oxynitride, and/or a low dielectric material. For example, a width of the connection contact plugs 41 in the first direction D1 and/or the second direction D2 may increase as the connection contact plugs 41 extend toward the first substrate 10 in the third direction D3. The connection contact plugs 41 and the first interconnection lines 43 may include a conductive material such as metal.

The cell insulating layer 40 may not cover lower surfaces of the second bonding pads 45; that is, the lower surfaces of the respective second bonding pads 45 may be exposed through the cell insulating layer 40. A lower surface of the cell insulating layer 40 may be substantially vertically coplanar with the lower surfaces of the second bonding pads 45. The lower surface of each of the second bonding pads 45 may be in direct contact with an upper surface of each of the first bonding pads 35. The first and second bonding pads 35 and 45 may include metal such as copper (Cu), tungsten (W), aluminum (Al), nickel (Ni), or tin (Sn). As an example, the first and second bonding pads 35 and 45 may include copper (Cu). The first and second bonding pads 35 and 45 may form an integrated shape without an interface therebetween. It is shown that the first and second bonding pads 35 and 45 may be provided such that side walls thereof are aligned to each other in the third direction D3, but the inventive concept is not limited thereto. Alternatively, when viewed in a plan view, the side walls of the first and second bonding pads 35 and 45 may be spaced apart from each other.

Bit lines BL and second interconnection lines CL in contact with the connection contact plugs 41 may be provided on the cell insulating layer 40. For example, each of the bit lines BL and the second interconnection lines CL may extend in the second direction D2 and be spaced apart from each other in the first direction D1. The bit lines BL and the second interconnection lines CL may include a conductive material such as metal.

A stack structure ST may be provided on the cell insulating layer 40. The semiconductor layer 191 and an upper insulating layer 192 may be provided sequentially on the stack structure ST. The semiconductor layer 191 may be provided on the cell array region CAR and not on the extension region EXR. The stack structure ST may include a first stack structure ST1, a second stack structure ST2, and a third stack structure ST3 sequentially provided between the semiconductor layer 191 and the cell insulating layer 40. In this specification, for simplicity of explanation, the description is based on three stack structures, but there may be three or more stack structures. The stack structure ST may include a structure in which interlayer insulating layers and conductive patterns are alternately stacked in the third direction D3.

The first stack structure ST1 may include alternately stacked interlayer insulating layers 111 and first word lines EL1, and the second stack structure ST2 may include alternately stacked interlayer insulating layers 111 and second word lines EL2, and the third stack structure ST3 may include alternately stacked interlayer insulating layers 111 and third word lines EL3. The first stack structure ST1 may be provided between the second stack structure ST2 and the semiconductor layer 191. In detail, the uppermost interlayer insulating layer 111 of the second stack structure ST2 may be in contact with the lowermost interlayer insulating layer 111 of the first stack structure ST1. Similarly, the second stack structure ST2 may be provided between the third stack structure ST3 and the first stack structure ST1. In detail, the uppermost interlayer insulating layer 111 of the third stack structure ST3 may be in contact with the lowermost interlayer insulating layer 111 of the second stack structure ST2.

The first to third word lines EL1, EL2, and EL3 may be formed simultaneously of the same material. The first to third word lines EL1, EL2, and EL3 may include, for example, at least one material selected from a doped semiconductor (e.g., doped silicon, etc.), a metal (e.g., tungsten, molybdenum, nickel, copper, aluminum, etc.), a conductive metal nitride (e.g., titanium nitride, tantalum nitride, etc.) or a transition metal (e.g., titanium, tantalum, etc.). The interlayer insulating layers 111 may include, for example, silicon oxide, silicon nitride, silicon oxynitride, and/or a low dielectric material. For example, the interlayer insulating layers 111 may include high density plasma oxide (HDP oxide) or tetraethylorthosilicate (TEOS).

In the extension region EXR, each of the first, second, and third stack structures ST1, ST2, and ST3 may include inverted step-shaped end portions. Contact pads RP exposed by open regions VL may be provided at the step-shaped ends. The first stack structure ST1 may include a 1a-th buried insulating layer 131a that fills the open region VL extending into all of the first word lines EL1, and a 1b-th buried insulating layer 131b that extends into some of the first word lines EL1. The term "fills" (or "filling," "filled," or like terms), as may be used herein, is intended to refer broadly to either completely filling a defined space (e.g., the open region VL) or partially filling the defined space; that is, the defined space need not be entirely filled but may, for example, be partially filled or have voids or other spaces throughout. The 1a-th buried insulating layer 131a may cover 1a-th contact pads RP1a of the first word lines EL1, and the 1b-th buried insulating layer 131b may cover 1b-th contact pads RP1b of the first word lines EL1. The second stack structure ST2 may include a 2a-th buried insulating layer 132a that fills the open region VL extending into all of the second word lines EL2, and a 2b-th buried insulating layer 132b that extends into some of the second word lines EL2. The 2a-th buried insulating layer 132a may cover the 2a-th contact pads RP2a of the second word lines EL2, and the 2b-th buried insulating layer 132b may cover the 2b-th contact pads RP2b of the second word lines EL2. The third stack structure ST3 may include a 3a-th buried insulating layer 133a that fills the open region VL that extends into all of the third word lines EL3, and a 3b-th buried insulating layer 133b that extends into some of the third word lines EL3. The 3a-th buried insulating layer 133a may cover 3a-th contact pads RP3a of the third word lines EL3, and the 3b-th buried insulating layer 133b may cover 3b-th contact pads RP3b of the third word lines EL3.

In the cell array region CAR, vertical channel structures VS may be provided in vertical channel holes CH extending into the stack structure ST in the third direction D3. The vertical channel structures VS may correspond to the memory channel structures 4220 of FIGS. 3 and 4. Lower portions of the vertical channel structures VS may be connected to the bit lines BL. As an example, bit line contact plugs may be provided between the vertical channel structures VS and the bit lines BL. Upper portions of the vertical channel structures VS may be connected to the semiconductor layer 191. The semiconductor layer 191 may include a polycrystalline silicon layer. The semiconductor layer 191 may include a common source region that electrically connects the vertical channel structures VS in the stack structure ST. As an example, the semiconductor layer 191 may include a p-type doped region in a region adjacent to the vertical channel structures VS. The upper insulating layer 192 may include a silicon oxide layer.

In the extension region EXR, support structures DV extending into the stack structure ST in the third direction D3 may be provided. The support structures DV may include an insulating material such as a silicon oxide layer, but may otherwise have a structure similar to the vertical channel structures VS.

A width of the vertical channel holes CH in the first direction D1 and/or the second direction D2 may decrease with increasing distance from the peripheral circuit structure PS. The vertical channel holes CH may have steps whose widths in the first direction D1 and/or the second direction D2 change discontinuously at a boundary between the first and second stack structures ST1 and ST2 and at a boundary between the second and third stack structures ST2 and ST3. That is, the vertical channel holes CH are configured having a step difference, such that a first portion that extends along the interface between the first and second stack structures ST1 and ST2 is wider than a second portion that extends along the interface between the second and third stack structures ST2 and ST3.

Each of the vertical channel structures VS may include a conductive pad adjacent to the cell insulating layer 40, a data storage pattern, a vertical semiconductor pattern, and a buried insulating pattern that are sequentially provided in the vertical channel hole CH. The vertical semiconductor pattern may include, for example, a semiconductor material doped with impurities, an intrinsic semiconductor material in an undoped state, or a polycrystalline semiconductor material. The conductive pad may include, for example, a semiconductor material or a conductive material doped with impurities. The buried insulating pattern may include an insulating material such as a silicon oxide layer. Embodiments, however, are not limited to the specific materials mentioned for the vertical semiconductor pattern, the conductive pad, or the buried insulating pattern.

The data storage pattern may include a blocking insulating layer, a charge storage layer, and a tunneling insulating layer sequentially stacked on sidewalls of the vertical channel hole CH. Fowler-Nordheim (FN) tunneling phenomenon, which may be caused by a voltage difference between the vertical semiconductor pattern VSP and the first to third word lines EL1, EL2, and EL3, may be used to store or change data in the data storage pattern DSP. For example, the blocking insulating layer and the tunneling insulating layer may include silicon oxide, and the charge storage layer may include silicon nitride or silicon oxynitride.

Referring to FIGS. 5, 6, and 7, when viewed in plan view, a first trench TR1 and a second trench TR2 extending in the first direction D1 and crossing the stack structure ST may be provided. The first trench TR1 may be provided in the cell array region CAR and the extension region EXR, and the second trench TR2 may be provided in the extension region EXR (and not in the cell array region CAR). A first separation pattern SP1 and a second separation pattern SP2 may be provided to at least partially fill an interior of each of the first and second trenches TR1 and TR2. The first and second separation patterns SP1 and SP2 may correspond to the separation structures 4230 of FIG. 3. A length of the first separation pattern SP1 in the first direction D1 may be greater than a length of the second separation pattern SP2 in the first direction D1. Sidewalls of the first and second separation patterns SP1 and SP2 may be in contact with at least a portion of the first to third word lines EL1, EL2, and EL3 and the interlayer insulating layers 111 of the stack structure ST. The first and second separation patterns SP1 and SP2 may include, for example, an oxide such as silicon oxide.

When a plurality of stack structures ST are provided, a first separation pattern SP1 may be provided between the stack structures ST arranged in the second direction D2. In other words, the stack structures ST may be spaced apart from each other in the second direction D2 with the first separation pattern SP1 therebetween.

The cell contact plugs and structures adjacent thereto are described in more detail below.

As shown in FIGS. 5 to 8, cell contact plugs CP extending in the third direction D3 into the stack structure ST may be provided. Each of the cell contact plugs CP may continuously increase in horizontal width or diameter as the contact plug CP extends in the third direction D3. The cell contact plugs CP may include a metal material such as tungsten, titanium, or tantalum, although embodiments are not limited thereto. Each of the cell contact plugs CP may be connected to one of the first to third word lines EL1, EL2, and EL3, and the word lines other than the connected word lines may be spaced apart from the cell contact plugs CP with insulating spacers 141 provided therebetween. As an example, the insulating spacers 141 may include a silicon oxide layer. Each of the cell contact plugs CP may extend into the first stack structure ST1, the second stack structure ST2, and the third stack structure ST3 and be connected to the upper insulating layer 192. Each of the cell contact plugs CP may include a single continuous conductor without an interface between the first stack structure ST1 and the second stack structure ST2 and without an interface between the second stack structure ST2 and the third stack structure ST3.

The cell contact plugs CP may include first cell contact plugs CP1a and CP1b connected to the contact pads RP1a and RP1b, respectively, of the first word lines EL1, second cell contact plugs CP2a and CP2b connected to the contact pads RP2a and RP2b, respectively, of the second word lines EL2, and third cell contact plugs CP3a and CP3b connected to the contact pads RP3a and RP3b, respectively, of the third word lines EL3.

The second cell contact plugs CP2a and CP2b may include 2a-th cell contact plugs CP2a connected to the 2a-th contact pads RP2a and 2b-th cell contact plugs CP2b connected to the 2b-th contact pads RP2b. As shown in FIGS. 5 and 8, the second cell contact plugs CP2a and CP2b may include a first horizontal protrusion LP1 whose diameter in the first direction D1 and/or second direction D2 increases discontinuously at a connection portion of the first stack structure ST1 and the second stack structure ST2. That is, each of the second cell contact plugs CP2a and CP2b may be configured having a step difference, such that a width of the first horizontal protrusion LP1 extending in the first direction D1 and/or second direction D2 along the interface between the first and second stack structures ST1 and ST2 is greater than a width of the corresponding second cell contact plug CP2a, CP2b in the first direction D1 and/or second direction D2 outside of the interface between the first and second stack structures ST1 and ST2. In detail, as shown in FIGS. 9 and 10, the first horizontal protrusion LP1 may be provided within the lowermost interlayer insulating layer 111 of the first stack structure ST1. The first horizontal protrusion LP1 may vertically overlap the 2b-th contact pads RP2b or the 2a-th contact pads RP2a. The term "overlap" (or "overlapping," or like terms), as may be used herein, is intended to broadly refer to a first element that intersects with at least a portion of a second element in the vertical direction (i.e., the third direction D3), but does not require that the first and second elements be completely aligned with one another in a horizontal plane (i.e., in the first direction D1 and/or the second direction D2). For example, the term "overlap" (or "overlapping," or like terms), as may be used herein, is intended to broadly refer to a first element that at least partially overlaps with a second element when viewed in the vertical direction (i.e., the third direction D3). The first horizontal protrusion LP1 may be provided between the 2b-th contact pads RP2b and the semiconductor layer 191 or between the 2a-th contact pads RP2a and the upper insulating layer 192. The first horizontal protrusion LP1 may not be provided between the second and third stack structures ST2 and ST3. The first horizontal protrusion LP1 may not be provided between the 2b-th contact pads RP2b and the second interconnection line CL and between the 2a-th contact pads RP2a and the second interconnection line CL.

As shown in FIG. 10, the second cell contact plugs CP2a and CP2b may have a first width W1 in the first direction D1 in a region adjacent to the first horizontal protrusion LP1, and the first horizontal protrusion LP1 may have a second width W2 in the first direction D1 that is larger than the width W1. For example, the second width W2 may be about 1.2 to 3.0 times larger than the first width W1.

The horizontal protrusion LP1 may have a ring shape surrounding each of the second cell contact plugs CP2a and CP2b, but is not limited thereto. A thickness t1 in the third direction D3 of the horizontal protrusion LP1 may be smaller than the second width W2.

The third cell contact plugs CP3a and CP3b are 3a-th cell contact plugs CP3a connected to the 3a-th contact pads RP3a and 3b-th cell contact plugs CP3b connected to the 3b-th contact pads RP3b. As shown in FIGS. 6 and 9, the third cell contact plugs CP3a and CP3b may include a second horizontal protrusion LP2 whose diameter in the first direction D1 and/or second direction D2 increases discontinuously at the connection portion of the second stack structure ST2 and the third stack structure ST3. That is, each of the third cell contact plugs CP3a and CP3b may be configured having a step difference, such that a width of the second horizontal protrusion LP2 extending in the first direction D1 and/or second direction D2 along the interface between the second and third stack structures ST2 and ST3 is greater than a width of the corresponding third cell contact plug CP3a, CP3b in the first direction D1 and/or second direction D2 outside of the interface between the second and third stack structures ST2 and ST3. In detail, as shown in FIG. 9, the second horizontal protrusion LP2 may be provided within the lowermost interlayer insulating layer 111 of the second stack structure ST2. The second horizontal protrusion LP2 may vertically overlap the 3a-th contact pads RP3a or the 3b-th contact pads RP3b. The second horizontal protrusion LP2 may be provided between the 3b-th contact pads RP3b and the semiconductor layer 191 or between the 3a-th contact pads RP2a and the upper insulating layer 192. The second horizontal protrusion LP2 may not be provided between the second stack structure ST2 and the first stack structure ST1. The second horizontal protrusion LP2 may not be provided between the 2b-th contact pads RP2b and the second interconnection line CL and between the 2a-th contact pads RP2a and the second interconnection line CL.

The first cell contact plugs CP1a and CP1b connected to the first word lines EL1 in the first stack structure ST1 closest to the upper insulating layer 192 may not include a horizontal protrusion.

The first cell contact plugs CP1a and CP1b, the second cell contact plugs CP2a and CP2b, and the third cell contact plugs CP3a and CP3b may be placed sequentially and repeatedly in the first direction D1 as shown in FIGS. 5 to 7. In a direction opposite to the first direction D1, which is a direction away from the vertical channel structures VS, the third cell contact plugs CP3a and CP3b, the second cell contact plugs CP2a and CP2b, and the first cell contact plugs CP1a and CP1b may be repeatedly arranged multiple times. For example, 3b-th cell contact plugs CP3b, 2b-th cell contact plugs CP2b, 1b-th cell contact plugs CP1b, and 3a-th cell contact plugs CP3a, 2a-th cell contact plugs CP2a, and 1a-th cell contact plugs CP1a may be arranged sequentially, in a direction opposite to the first direction D1. The 2b-th cell contact plugs CP2b may be disposed between the 3b-th cell contact plugs CP3b and the 1b-th cell contact plugs CP1b, and the 2a-th cell contact plugs CP2a may be disposed between the 3a-th cell contact plugs CP3a and the 1a-th cell contact plugs CP1a.

The first and second horizontal protrusions LP1 and LP2 may prevent a leakage current and a short circuit between the contact plugs CP and adjacent word lines, due to misalignment of contact holes in a process forming contact plugs CP, which will be described below. The first and second horizontal protrusions LP1 and LP2 may not be formed at all interfaces between the stack structures, but may be formed at the closest interface among the interfaces of the stack structures disposed between the contact pads RP and the semiconductor layer 191, wherein the closest interface is the interface between the contact pads RP and the semiconductor layer 191 which is closest to the contact pads RP. That is, the first and second horizontal protrusions LP1 and LP2 may be disposed only at the interface of the stack structures immediately above the contact pads RP, thereby simplifying the process and increasing integration.

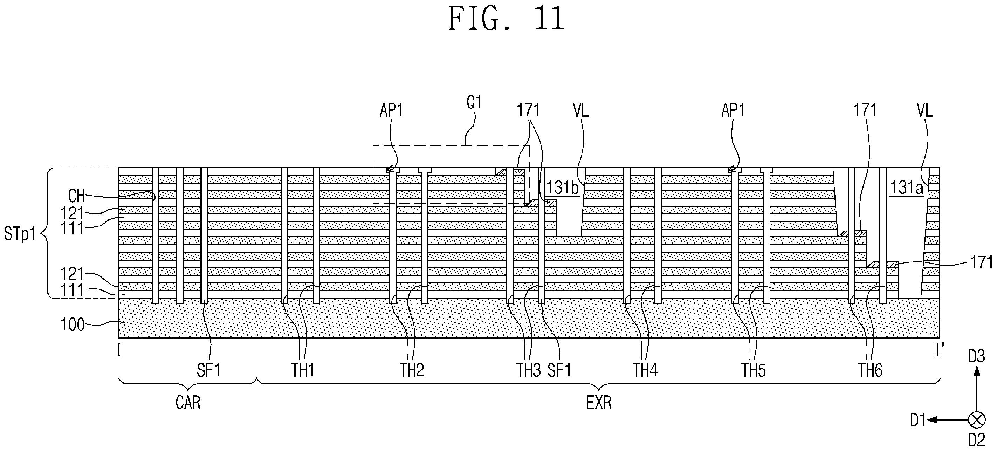

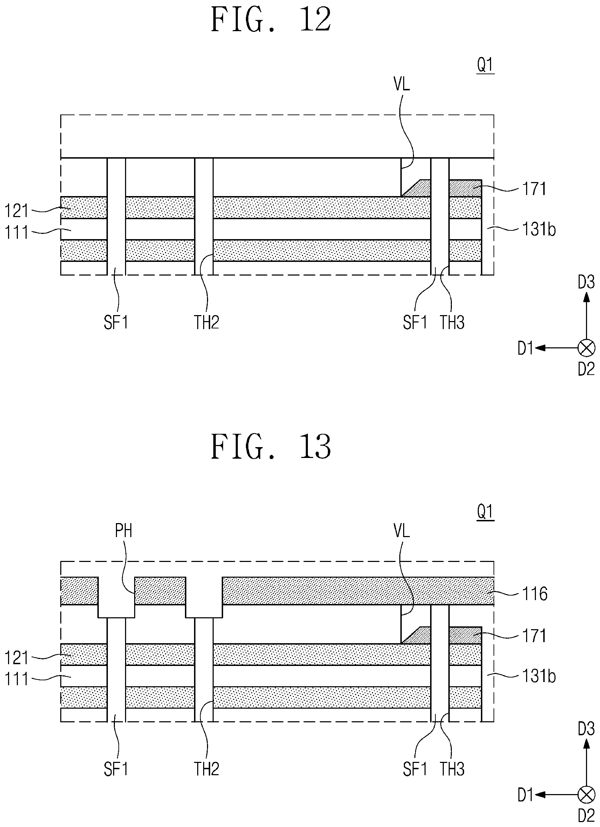

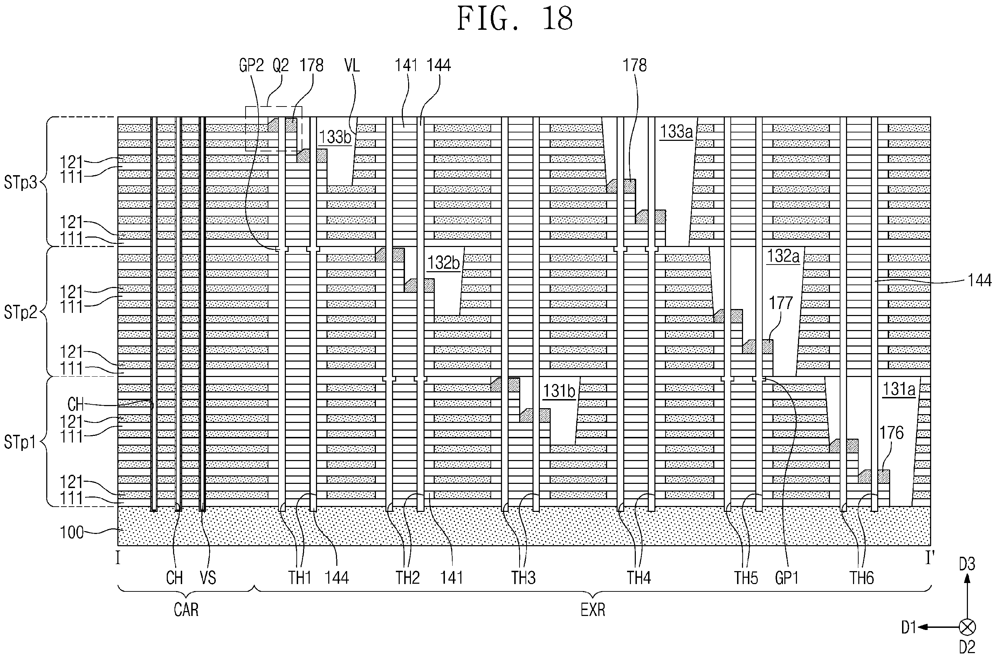

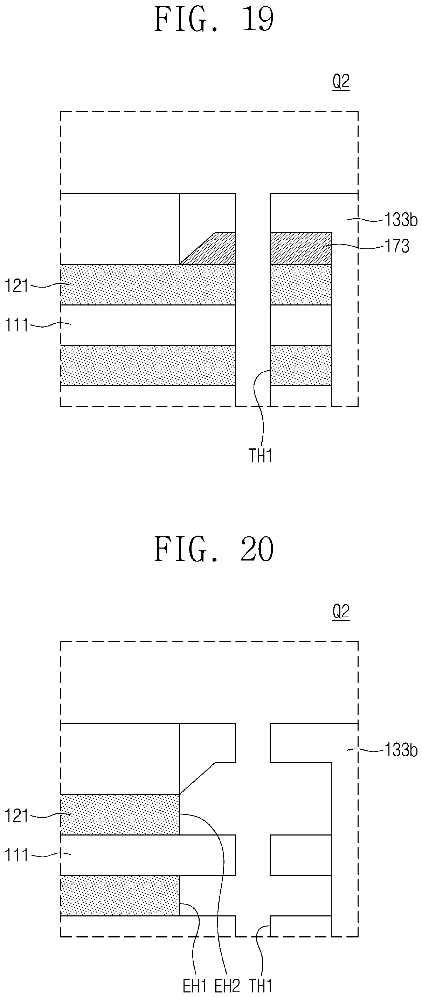

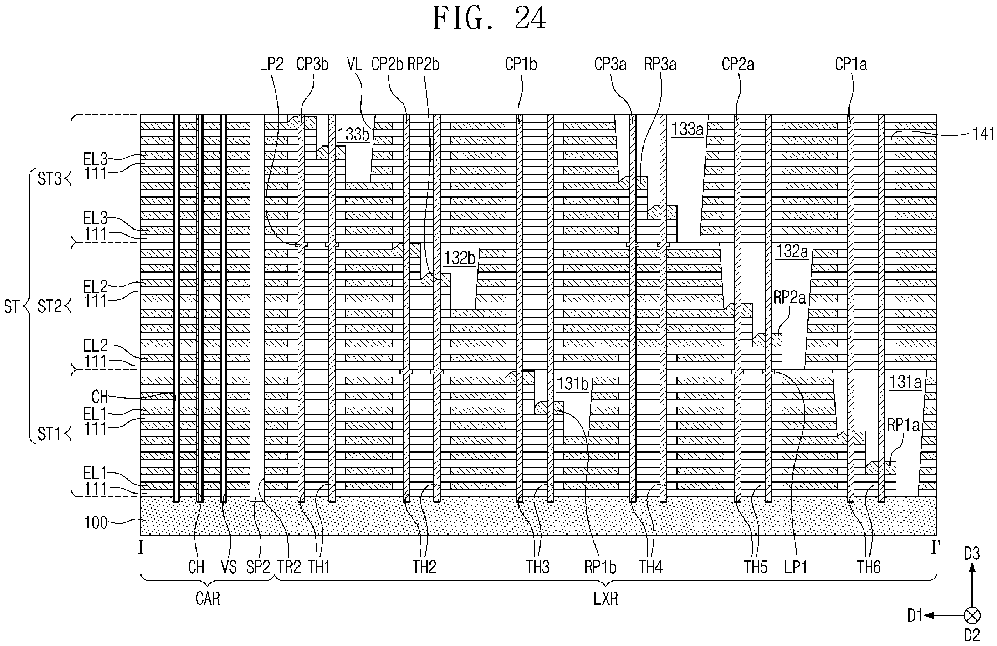

FIGS. 11, 15 to 18, and 23 to 24 are cross-sectional views taken along line I-I' of FIG. 5 illustrating intermediate processes in an example method of manufacturing a three-dimensional semiconductor memory device, according to one or more embodiments of the inventive concept. FIGS. 12 to 14 are enlarged cross-sectional views of region 'Q1' in FIG. 11. FIGS. 19 to 22 are enlarged cross-sectional views of region `Q2' in FIG.18.

Referring to FIG. 11, a first preliminary stack structure STp1 may be formed on a second substrate 100. The second substrate 100 may be, for example, a silicon substrate, a silicon-germanium substrate, a germanium substrate, or a single crystal epitaxial layer grown on a monocrystalline silicon substrate, although embodiments are not limited thereto. The second substrate 100 may have a first conductivity type. As an example, the first conductivity type may be p-type. Before the first preliminary stack structure STp1 is formed, a buffer insulating layer and/or an etch stop layer may be formed on the second substrate 100.

The first preliminary stack structure STp1 may include interlayer insulating layers 111 and sacrificial layers 121 that are alternately and repeatedly stacked in the third direction D3 (i.e., vertically). The interlayer insulating layers 111 and sacrificial layers 121 may be formed of different insulating materials. The sacrificial layers 121 may be formed of a material that may be etched with etch selectivity with respect to the interlayer insulating layers 111. For example, the sacrificial layers 121 may be formed of silicon nitride, and the interlayer insulating layers 111 may be formed of silicon oxide. Each of the sacrificial layers 121 may have substantially the same cross-sectional thickness. The uppermost layer of the interlayer insulating layers 111 may be thicker than the other layers.

In an extension region EXR, open regions VL exposing upper surfaces of the sacrificial layers 121 may be formed. As an example, the open regions VL may be formed through a plurality of etching processes through forming a mask pattern and trimming the mask pattern. As a result, sidewalls of the open regions VL may be formed to have a step shape (when viewed in cross section) defined by the upper surfaces of the sacrificial layers 121. A plurality of open regions VL may be provided, and the number of sacrificial layers 121 through which the open regions VL penetrate (i.e., extend into) may be changed depending on positions thereof. For example, as a distance from the cell array region CAR in a direction opposite to the first direction D1 increases, a depth of the open region VL a direction opposite to the third direction D3 may increase.

Referring to FIGS. 11 and 12, first pad sacrificial patterns 171 may be formed on the upper surfaces of the sacrificial layers 121 exposed by the open regions VL. A sacrificial layer covering the open regions VL may be formed and then the sacrificial layer may be removed from regions excluding the exposed upper surfaces of the sacrificial layers 121 to form the first pad sacrificial patterns 171. The first pad sacrificial patterns 171 may be formed of a material that may be etched with etch selectivity with respect to the interlayer insulating layers 111. For example, the first pad sacrificial patterns 171 may be formed of the same material as the sacrificial layers 121, for example, silicon nitride. Afterwards, 1a-th buried insulating layer 131a and 1b-th buried insulating layer 131b may be formed to fill the open regions VL. The 1a-th buried insulating layer 131a and the 1b-th buried insulating layer 131b may include a silicon oxide layer, although embodiments are not limited thereto.

Through holes TH1 to TH6 extending vertically (i.e., in the third direction D3) into the first preliminary stack structure STp1 in the extension region EXR and vertical channel holes CH extending vertically into the first preliminary stack structure STp1 in the cell array region CAR may be formed. The through holes TH1 to TH6 and the vertical channel holes CH may be formed simultaneously through an anisotropic etching process. The through holes TH1 to TH6 and the vertical channel holes CH may expose the second substrate 100. First through sacrificial patterns SF1 may be formed to fill the through holes TH1 to TH6 and the vertical channel holes CH. The first through sacrificial patterns SF1 may be formed of a material that may be etched with etch selectivity to the interlayer insulating layers 111 and the sacrificial layers 121. As an example, the first through sacrificial patterns SF1 may include either polycrystalline silicon or silicon carbide, although embodiments are not limited thereto.

Referring to FIGS. 11 and 13, a mask pattern 116 may be formed to cover an upper surface of the first preliminary stack structure STp1 and expose some of the through holes TH1 to TH6. The mask pattern 116 may include photoresist and/or silicon nitride, although embodiments are not limited thereto. As an example, the mask pattern 116 may include openings that overlap the second through holes TH2 and the fifth through holes TH5 in the third direction D3. Recess regions PH in which an upper portion of the first through sacrificial patterns SF1 exposed by the openings and a portion of the uppermost interlayer insulating layer 111 are removed may be formed.

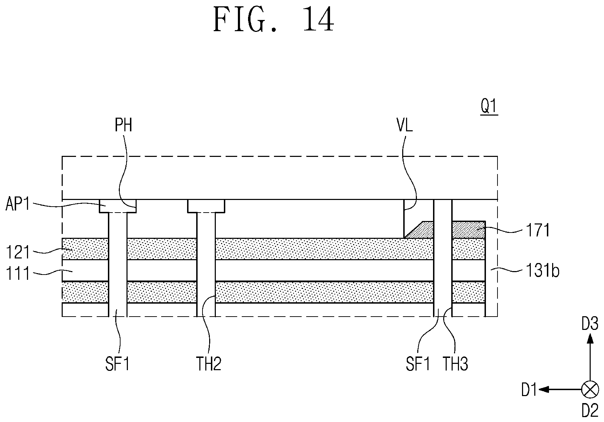

Referring to FIGS. 11 and 14, first extension patterns AP1 may be formed to at least partially fill the recess regions PH. The first extension patterns AP1 may be formed of the same material as the first through sacrificial patterns SF1. After this, the mask pattern 116 may be removed.

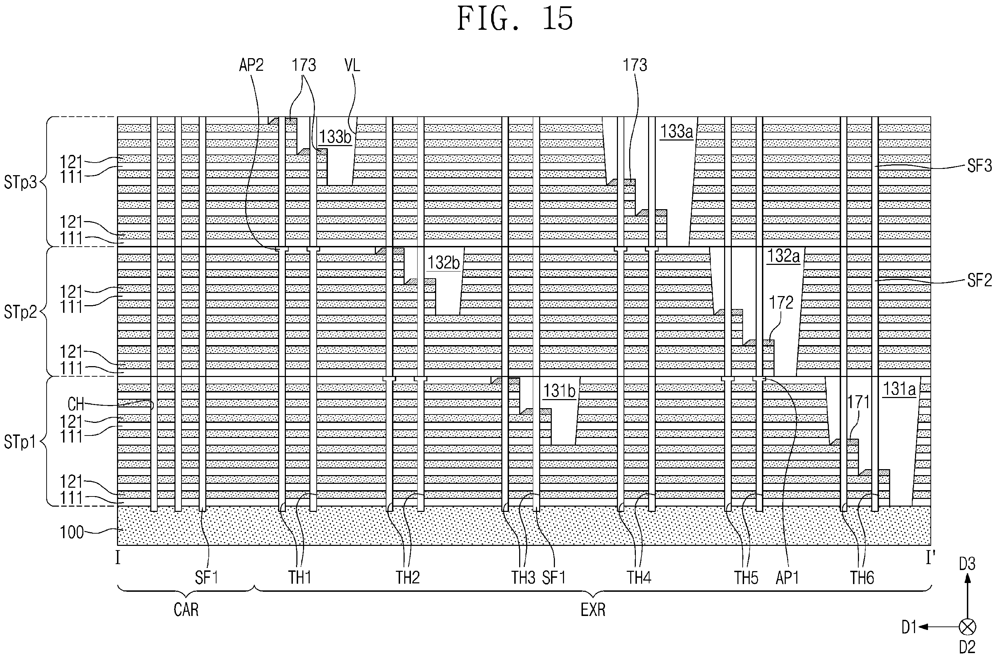

Referring to FIG. 15, second preliminary stack structure STp2 and third preliminary stack structure STp3 may be sequentially formed on the first preliminary stack structure STp1. The second preliminary stack structure STp2 may be formed by repeating a process similar to that of the first preliminary stack structure STp1. As a result, second pad sacrificial patterns 172, a 2a-th buried insulating layer 132a, and a 2b-th buried insulating layer 132b may be formed in the open regions VL in the second preliminary stack structure STp2, and second through sacrificial patterns SF2 may be formed on each of the first through sacrificial patterns SF1, respectively. Second extension patterns AP2 may be formed on some of the second through sacrificial patterns SF2. Similarly, third pad sacrificial patterns 173, a 3a-th buried insulating layer 133a, and a 3b-th buried insulating layer 133b may be formed in the open regions VL in the third preliminary stack structure STp3, and third through sacrificial patterns SF3 may be formed on the second through sacrificial patterns SF2, respectively. Extension patterns may not be formed in the third through sacrificial patterns SF3.

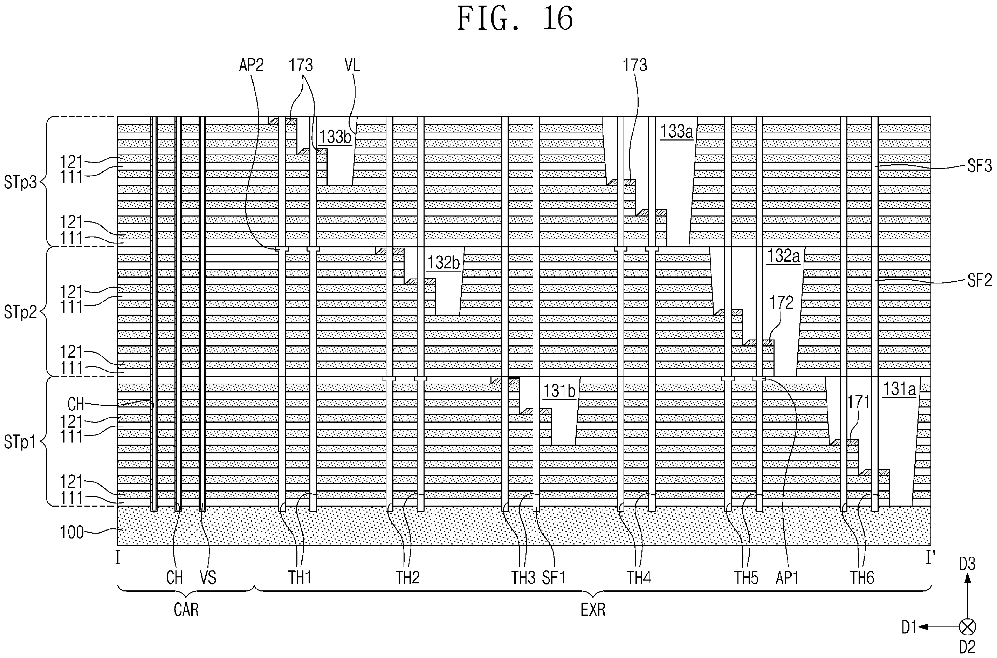

Referring to FIG. 16, after removing the first to third through sacrificial patterns SF1, SF2, and SF3 in the vertical channel holes CH of the first to third preliminary stack structures STp1, STp2, and STp3, the vertical channel structures VS may be formed. Hereinafter, each of the vertical channel holes CH may refer to one hole sequentially extending vertically into or through the first to third preliminary stack structures STp1, STp2, and STp3. Forming the vertical channel structures VS may include forming a data storage pattern and a vertical semiconductor pattern that conformally covers inner sidewalls of the vertical channel holes CH, and forming a buried insulating pattern in a space surrounded by the vertical semiconductor pattern.

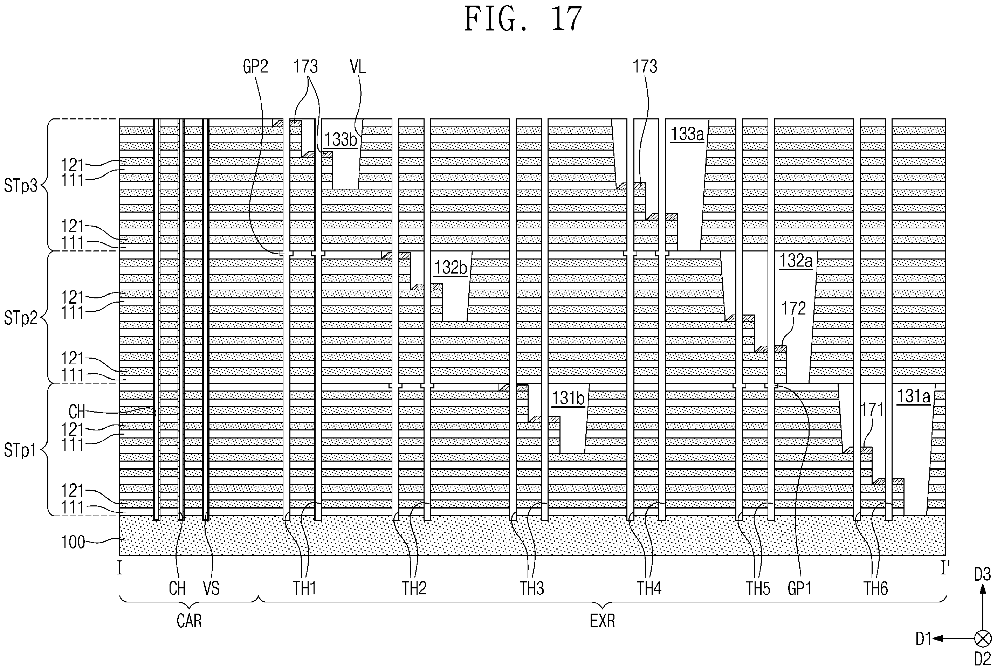

Referring to FIG. 17, the first to third through sacrificial patterns SF1, SF2, and SF3 may be removed in the extension region EXR to expose the first to sixth through holes TH1 to TH6. Hereinafter, each of the first to sixth through-holes TH1 to TH6 may refer to a hole sequentially passing through the first to third preliminary stack structures STp1, STp2, and STp3 in the third direction D3. When removing the first to third through sacrificial patterns SF1, SF2, and SF3, the first and second extension patterns AP1 and AP2 may be also removed to form first gap regions GP1 and second gap regions GP2, respectively.

Referring to FIGS. 18, 19, and 20, portions of the sacrificial layers 121 exposed by the first to sixth through holes TH1 to TH6 may be removed. The sacrificial layers 121 may not be completely removed and only portions close to the first to sixth through holes TH1 to TH6 may be horizontally etched. As a result, first horizontal recess regions EH1 in which the first to sixth through holes TH1 to TH6 are horizontally expanded may be formed. The first to third pad sacrificial patterns 171, 172, and 173 may be removed together with the sacrificial layers 121. As a result, some of the first horizontal recess regions EH1 may become second horizontal recess regions EH2 whose cross-sectional thickness in the third direction D3 is further expanded.

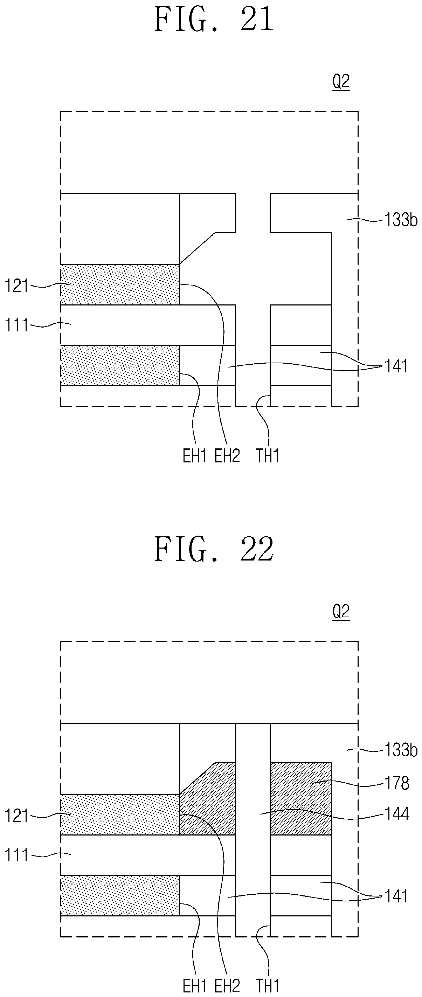

Referring to FIGS. 18 and 21, insulating spacers 141 may be formed in the first horizontal recess regions EH1. The insulating spacers 141 may include the same material as the interlayer insulating layers 111, for example, a silicon oxide layer. The forming of the insulating spacers 141 may include forming an insulating layer covering the first horizontal recess regions EH1 and the second horizontal recess regions EH2, and then performing anisotropic etching to remove the remaining insulating layer in the first to sixth through holes TH1 to TH6. A cross-sectional thickness of the second horizontal recess regions EH2 in the third direction D3 may be larger than that of the first horizontal recess regions EH1, and thus the insulating layer in the second horizontal recess regions EH2 may be removed together when the remaining insulating layer is removed. For example, a portion of the insulating layer in the second horizontal recess regions EH2 having a larger thickness in the third direction D3 may be removed before a portion of the insulating layer in the first horizontal recess regions EH1 is completely removed because the contact area with the etchant increases rapidly during the etching process.

After forming the insulating spacers 141, fourth to sixth pad sacrificial patterns 176, 177, and 178 may be formed in the second horizontal recess regions EH2. The fourth to sixth pad sacrificial patterns 176, 177, and 178 may be formed of a material that may be removed together with the sacrificial layers 121. As an example, the fourth to sixth pad sacrificial patterns 176, 177, and 178 may be formed of silicon nitride. Afterwards, vertical sacrificial patterns 144 may be formed to fill the first to sixth through holes TH1 to TH6. The vertical sacrificial patterns 144 may be formed of a material that may be etched with etch selectivity to the interlayer insulating layers 111 and the sacrificial layers 121. As an example, the vertical sacrificial patterns 144 may include either polycrystalline silicon or silicon carbide. The vertical sacrificial patterns 144 may fill the first gap regions GP1 and the second gap regions GP2.

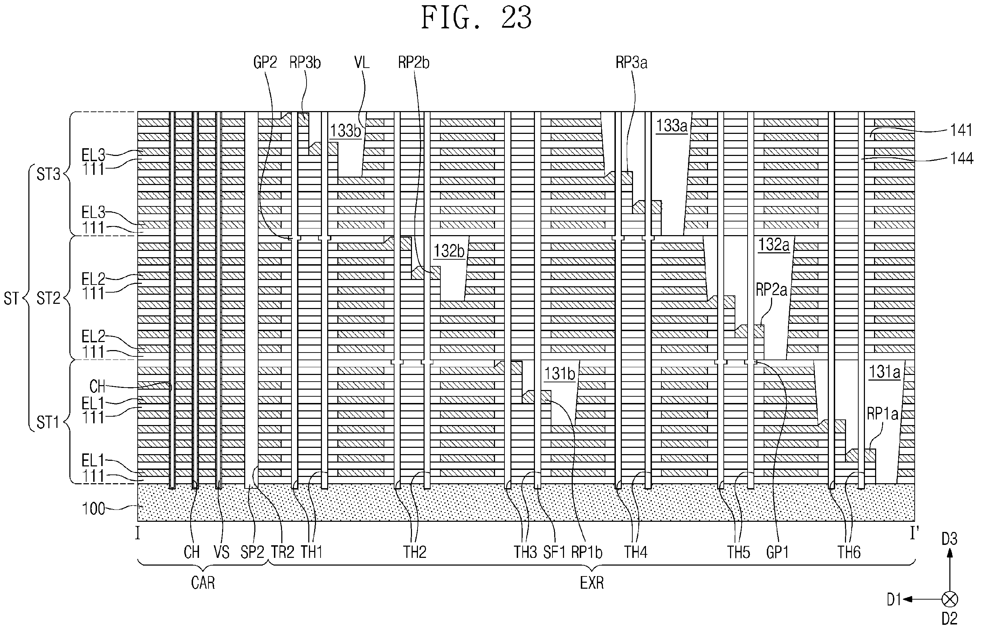

Referring to FIGS. 5 and 23, first and second trenches TR1 and TR2 extending vertically into or through the first to third preliminary stack structures STp1, STp2, and STp3 may be formed. The first and second trenches TR1 and TR2 may extend in the first direction D1 from the cell array region CAR to the extension region EXR. The sacrificial layers 121 may be removed through the first and second trenches TR1 and TR2. Removing the sacrificial layers 121 may be performed, for example, through a wet etching process using a hydrofluoric acid (HF) and/or phosphoric acid (H₃PO₄) solution. The fourth to sixth pad sacrificial patterns 176, 177, and 178 may also be removed together with the sacrificial layers 121.

First to third word lines EL1, EL2, and EL3 may be formed to fill spaces where the sacrificial layers 121 have been removed. Contact pads RP may be formed in the spaces where the sacrificial patterns 176, 177, and 178 have been removed. Accordingly, a stack structure ST including the first stack structure ST1, the second stack structure ST2, and the third stack structure ST3 may be formed. Afterwards, a first separation pattern SP1 and a second separation pattern SP2 may be formed to fill the first and second trenches TR1 and TR2, respectively.

Referring to FIGS. 5 to 7 and FIG. 24, after the vertical sacrificial patterns 144 are removed, cell contact plugs CP may be formed to fill spaces where the vertical sacrificial patterns 144 were removed. Cell contact plugs CP may be formed of a metal material such as tungsten, titanium, or tantalum, although embodiments are not limited thereto. First horizontal protrusions LP1 may be formed in the first gap regions GP1, and second horizontal protrusions LP2 may be formed in the second gap regions GP2.

Referring again to FIG. 8, bit lines BL, second interconnection lines CL, connection contact plugs 41, first interconnection lines 43, second bonding pads 45, and a cell insulating layer 40 covering the bit lines BL, the second interconnection lines CL, the connection contact plugs 41, the first interconnection lines 43, and the second bonding pads 45, may be formed on the stack structure ST. Accordingly, forming the cell array structure CS may be completed. Afterwards, the cell array structure CS and the peripheral circuit structure PS may be combined with each other. In detail, the cell array structure CS and the peripheral circuit structure PS may be bonded (e.g., using a wafer bonding process) such that the second bonding pads 45 are in contact with the first bonding pads 35. Afterwards, the second substrate 100 may be removed to expose upper portions of the vertical channel structures VS and upper portions of the cell contact plugs CP.

A semiconductor layer 191 may be formed covering the exposed upper portions of the vertical channel structures VS. The semiconductor layer 191 may not be formed on the cell contact plugs CP. An upper insulating layer 192 may be formed over the cell contact plugs CP. The upper insulating layer 192 may cover the semiconductor layer 191.

According to embodiments of the inventive concept, the contact plugs may include the horizontal protrusions to prevent a leakage current and a short circuit between the contact plugs and the adjacent word lines. For example, referring to Fig. 15, when forming a contact hole provided with the third through sacrificial patterns SF3, a large area of the horizontal protrusions of the second through sacrificial patterns SF2 may allow the third through sacrificial patterns SF3 to be connected to the second through sacrificial patterns SF2 even if the contact hole is misaligned. As a result, the final contact plugs can be prevented from being disconnected or incorrectly connected. Additionally, the horizontal protrusions may be disposed only at the closest interface among the interfaces of the stack structures disposed between the contact pads and the semiconductor layer, wherein the closest interface is the interface between the contact pads and the semiconductor layer which is closest to the contact pads RP, thereby simplifying the process and increasing integration.

While embodiments are described above, a person skilled in the art may understand that many modifications and variations are made without departing from the scope of the inventive concept defined in the following claims. Accordingly, the example embodiments of the inventive concept should be considered in all respects as illustrative and not restrictive, with the scope of the inventive concept being indicated by the appended claims.

## Claims

1. A semiconductor memory device (1100), comprising:
a cell array structure (CS) and a peripheral circuit structure (PS), the cell array structure (CS) provided on the peripheral circuit structure (PS) in a vertical direction (D3),
wherein the cell array structure (CS) includes:
a first stack structure (ST1), a second stack structure (ST2) on the first stack structure (ST1), and a third stack structure (ST3) on the second stack structure (ST2), each of the first, second, and third stack structures (ST1, ST2, ST3) including a plurality of word lines (EL1, EL2, EL3);
vertical channel structures (VS) extending into the first, second, and third stack structures (ST1, ST2, ST3); and
a second cell contact plug (CP2a, CP2b) extending into the first, second, and third stack structures (ST1, ST2, ST3) and connected to a second contact pad (RP2a, RP2b) at an end of a second word line (EL2) in the second stack structure (ST2), and
wherein the second cell contact plug (CP2a, CP2b) includes a first horizontal protrusion (LP1) having a horizontal width that increases discontinuously at a connection portion of the first stack structure (ST1) and the second stack structure (ST2).

2. The semiconductor device (1100) of claim 1, further comprising a third cell contact plug (CP3a, CP3b) extending into the first to third stack structures (ST1, ST2, ST3) and connected to a third contact pad (RP3a, RP3b) at an end of a third word line (EL3) in the third stack structure (ST3),
wherein the third cell contact plug (CP3a, CP3b) includes a second horizontal protrusion (LP2) having a horizontal width that increases discontinuously at a connection portion of the third stack structure (ST3) and the second stack structure (ST2).

3. The semiconductor device (1100) of claim 2, wherein the third cell contact plug (CP3a, CP3b) does not include a horizontal protrusion at a connection portion of the first stack structure (ST1) and the second stack structure (ST2).

4. The semiconductor device (1100) of claim 2 or 3, further comprising a first cell contact plug (CP1a, CP1b) extending into the first to third stack structures (ST1, ST2, ST3) and connected to a first contact pad (RP1a, RP1b) at an end of a first word line (EL1) in the first stack structure (ST1),
wherein the first cell contact plug (CP1a, CP1b) does not include a horizontal protrusion.

5. The semiconductor device (1100) of claim 4, wherein the second cell contact plug (CP2a; CP2b) is between the first cell contact plug (CP1a; CP1b) and the vertical channel structures (VS), and
wherein the third cell contact plug (CP3a; CP3b) is between the second cell contact plug (CP2a; CP2b) and the vertical channel structures (VS).

6. The semiconductor device (1100) of claim 4 or 5, wherein the third cell contact plug (CP3a; CP3b), the second cell contact plug (CP2a; CP2b), and the first cell contact plug (CP1a; CP1b) are arranged repeatedly a plurality of times in a horizontal direction extending away from the vertical channel structures (VS).

7. The semiconductor device (1100) of any preceding claim, wherein the first horizontal protrusion (LP1) is spaced apart from the peripheral circuit structure (PS) with the second contact pad (RP2a, RP2b) therebetween.

8. The semiconductor device (1100) of any preceding claim, wherein the first horizontal protrusion (LP1) vertically overlaps the second contact pad (RP2a, RP2b).

9. The semiconductor device (1100) of any preceding claim, wherein the second cell contact plug (CP2a; CP2b) does not include a horizontal protrusion at a connection portion of the second stack structure (ST2) and the third stack structure (ST3).

10. The semiconductor device (1100) of any preceding claim, wherein the second cell contact plug (CP2a; CP2b) has a first horizontal width (W1) in a region adj acent to the first horizontal protrusion (LP1),
wherein the first horizontal protrusion (LP1) has a second horizontal width (W2), and
wherein the second horizontal width (W2) is 1.2 to 3.0 times the first horizontal width (W1).

11. The semiconductor device (1100) of claim 10, wherein a cross-sectional thickness of the first horizontal protrusion (LP1) is smaller than the second horizontal width (W2).

12. The semiconductor device (1100) of any preceding claim, further comprising insulating spacers (141) horizontally separating the second cell contact plug (CP2a; CP2b) from a first word line (EL1) of the first stack structure (ST1) and a third word line (EL3) of the third stack structure (ST3).
